# EUROPÄISCHE PATENTSCHRIFT

(11) **EP 0 753 204 B1**
(45) Veröffentlichungstag und Bekanntmachung des Hinweises auf die Patenterteilung: **27.05.1998**
(21) Anmeldenummer: 95911212.9
(22) Anmeldetag: 07.03.1995
(51) Int. Cl.: H01L 21/28, H01L 23/482, H01L 23/48, H01L 25/065

(54) **VERFAHREN ZUM HERSTELLEN EINES HALBLEITERBAUELEMENTES FÜR VERTIKALE INTEGRATION UND VERWENDUNG FÜR TEST-ZWECKE**
METHOD OF FROMING SEMICONDUCTOR COMPONENT DESIGNED FOR VERTICAL INTEGRATION AND USE FOR TESTING PURPOSES
PROCEDE DE FABRICATION D'UN COMPOSANT SEMICONDUCTEUR POUR INTEGRATION VERTICALE ET UTILISATION POUR TEST

(30) Priorität: 29.03.1994 DE 4410947
(43) Veröffentlichungstag der Anmeldung: 15.01.1997
(73) Patentinhaber: SIEMENS AKTIENGESELLSCHAFT, 80333 München (DE)
(72) Erfinder: KLOSE, Helmut, D-81929 München (DE); WEBER, Werner, D-80637 München (DE); BERTAGNOLLI, Emmerich, D-80799 München (DE); KÖPPE, Siegmar, D-30880 Laatzen (DE); HÜBNER, Holger, D-85598 Baldham (DE)
(86) Internationale Anmeldenummer: DE9500313
(87) Internationale Veröffentlichungsnummer: WO9526568

(56) Entgegenhaltungen:
- EP-A- 0 078 337
- EP-A- 0 238 089
- EP-A- 0 295 914
- FR-A- 2 188 309
- US-A- 3 760 238

## Beschreibung

Die vorliegende Erfindung betrifft ein Herstellungsverfahren für ein Halbleiterbauelement für vertikale Integration mit für reversible Kontaktierung speziell ausgebildeten Anschlußkontakten sowie eine zugehörige Verwendung.

Die vertikale Integration von Halbleiterbauelementen, d. h. die Anordnung verschiedener Funktionsebenen übereinander, erlaubt eine parallele Kommunikation dieser Komponenten mit geringem Aufwand elektrisch leitender Verbindung in einer Ebene, und außerdem werden geschwindigkeitsbegrenzende Interchip-Verbindungen vermieden. Außerdem kann ein solcher vertikal integrierter Halbleiterchip trotz gesteigerter Funktionalität in demselben Gehäuse untergebracht werden. Sowohl für die Herstellung dieser Bauelemente als auch für den erforderlichen Test einzelner darin integrierter Schaltungsebenen ist es erforderlich, eine Möglichkeit der reversiblen Kontaktierung für diese Schaltungsebenen mit extrem miniaturisierten Anschlüssen zur Verfügung zu haben.

In der FR-A-2 188 309 ist ein Halbleiterbauelement beschrieben, auf dessen Oberseite ein Kontakt an einem flexiblen Metallarm befestigt ist. Dieser Kontakt dient einer Montage des Bauelementes auf einer Platine, wobei der Kontakt auf eine Kontaktfläche der Platine gedrückt wird und die mechanische Spannung in dem Metallarm eine ausreichend feste Berührung der Kontakte gewährleistet. In der EP 0 238 089 A3 sind ein dreidimensional integrierter Schaltkreis und ein zugehöriges Herstellungsverfahren beschrieben. Mehrere Halbleiterebenen mit Anschlußkontakten an den Oberseiten sind in einem vertikalen Stapel angeordnet und durch ein thermoplastisches Harz dauerhaft miteinander verbunden.

Aufgabe der vorliegenden Erfindung ist es, ein Verfahren zum Herstellen eines Halbleiterbauelementes anzugeben, das für reversible vertikale Integration, insbesondere zum Zweck des Testens weiterer Schaltungsebenen, geeignet ist. Außerdem soll die Verwendung zum Zweck des Testens eines weiteren Bauelementes angegeben werden.

Diese Aufgaben werden mit dem Verfahren mit den Merkmalen des Anspruches 1 und mit der Verwendung nach Anspruch 3 gelöst.

Bei dem Halbleiterbauelement sind Anschlußkontakte für vertikale Kontaktierung auf einer Oberseite angebracht. Diese Kontakte sitzen auf einer strukturierten Metallschicht, die in einer Schichtstruktur des Bauelementes verankert ist und in der Art einer Blattfeder in eine Öffnung in dem Halbleitermaterial hineinragt. Auf dem in diese Öffnung ragenden Ende dieser z. B. streifenförmigen Metallschicht sitzt jeweils ein Kontakt, der die betreffende Oberseite des Bauelementes so weit überragt, daß bei vertikalem Zusammenschluß mit einem weiteren Bauelement diese Kontakte auf Anschlußflächen des weiteren Bauelementes gedrückt werden, wenn die einander zugewandten Oberseiten der beiden Bauelemente miteinander in Berührung gebracht werden. Durch die blattfederartigen Metallschichten ist der jeweilige Metallkontakt so beweglich angebracht, daß die ansonsten planaren Oberseiten der Bauelemente aufeinandergepreßt werden können, wobei der Kontakt in die Öffnung zurückgedrückt wird und gleichzeitig einen für elektrische Verbindungen ausreichend festen Druck auf die gegenüberliegende Kontaktfläche ausübt. Auf diese Weise wird erreicht, daß die einzelnen Bauelementebenen, die vertikal übereinander anzuordnen sind, jeweils zueinander planare Oberflächen aufweisen und gleichzeitig durch eine Art federnder Andruck die Kontakte des einen Bauelementes auf die Anschlußflächen des anderen Bauelementes gedrückt werden. Da die elektrisch leitende Verbindung zwischen verschiedenen Schaltungsebenen auf diese Weise hergestellt wird, ohne daß die Anschlußkontakte dauerhaft miteinander verbunden werden müssen, ist eine reversible vertikale elektrische Verbindung verschiedener Schaltungsebenen möglich. Das ist besonders vorteilhaft, wenn das Halbleiterbauelement zu Testzwecken mit einer weiteren Bauelementeebene verbunden werden soll. Ebenso ist es von Vorteil, wenn bei der Herstellung eines vertikal integrierten Chips die jeweils gefertigten Teilstapel auf Funktionstüchtigkeit hin überprüft werden sollen und bei Fehlfunktionen die zuletzt hinzugefügte Schaltungsebene wieder entfernt und durch eine andere ersetzt werden können soll. Bei einwandfreier Funktion der vertikal verbundenen Schaltungsebenen kann die zuletzt hinzugefügte Ebene, die entsprechend der vorliegenden Erfindung realisiert ist, dauerhaft mit dem restlichen Teilstapel verbunden werden, z. B. indem sie erwärmt wird und dadurch eine zuvor aufgebrachte Klebeschicht aktiviert wird.

Es folgt eine Beschreibung des erfindungsgemäßen Herstellungsverfahrens anhand der Figuren 1 bis 6.
- Fig. 1 bis 4: zeigen Zwischenprodukte für das Halbleiterbauelement nach verschiedenen Schritten des erfindungsgemäßen Herstellungsverfahrens im Querschnitt.
- Fig. 5: zeigt ein typisches Ausführungsbeispiel des Bauelementes im Querschnitt.
- Fig. 6: zeigt beispielhaft den vertikalen Zusammenbau eines Bauelementes mit einem weiteren Bauelement.

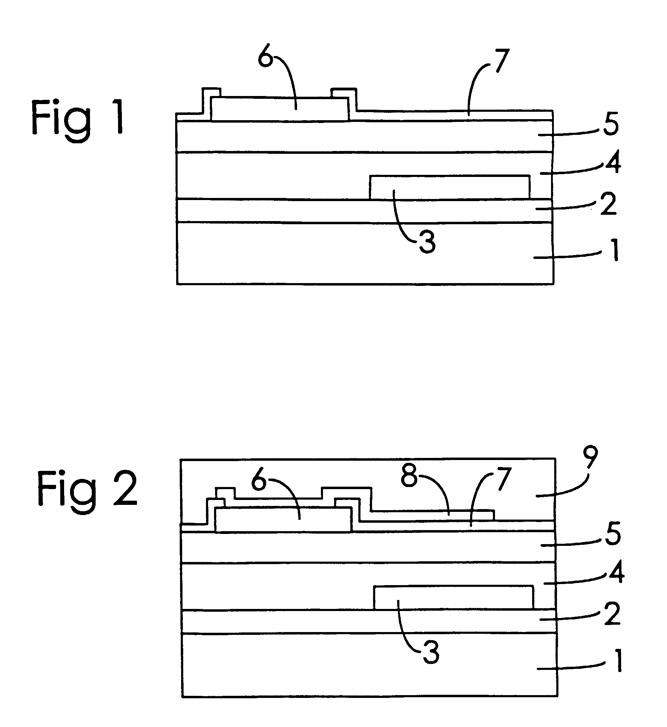

In Fig. 1 ist dargestellt, wie auf einem Substrat 1 eine Schichtstruktur für die vorgesehene Funktionsweise des fertigen Bauelementes aufgebracht ist. Als Beispiel ist hier auf dem Substrat 1 eine untere Dielektrikumschicht 2, z. B. ein Isolationsoxid, als Isolation aufgebracht. Bei Verwendung eines semiisolierenden Substrates kann diese Schicht entfallen. Die lateral begrenzte Schicht 3 soll ein in dem Bauelement integriertes Funktionselement darstellen. Bei einem IC auf Silizium kann diese Schicht 3 z. B. eine Polysiliziumschicht für das Gate eines Transistors sein. Diese leitfähige Struktur wird in weitere Dielektrikumschichten 4, 5 eingebettet, wobei die erste Dielektrikumschicht 4 eine Planarisierung der Oberfläche bewirkt. In diesen Dielektrikumschichten 4, 5 befinden sich entsprechende Kontakt löcher für den elektrischen Anschluß der Struktur der Funktionselemente zu auf der Oberseite der oberen Dielektrikumschicht 5 aufgebrachten Metallisierungen 6. Diese Metallisierungen 6, z. B. Anschlußkontakte oder Leiterbahnen, werden mit einer Isolierungsschicht 7 bedeckt, in der Öffnungen zum Freilegen der Metallisierungen 6 hergestellt werden.

Es kann dann entsprechend Fig. 2 eine Metallschicht derart aufgebracht und strukturiert werden, daß der verbleibende Anteil dieser Schicht als Anschlußmetallisierung 8 mit der freien Anschlußfläche der Metallisierung 6 verbunden ist. Die Oberseite wird dann wieder in eine Dielektrikumschicht 9 eingebettet.

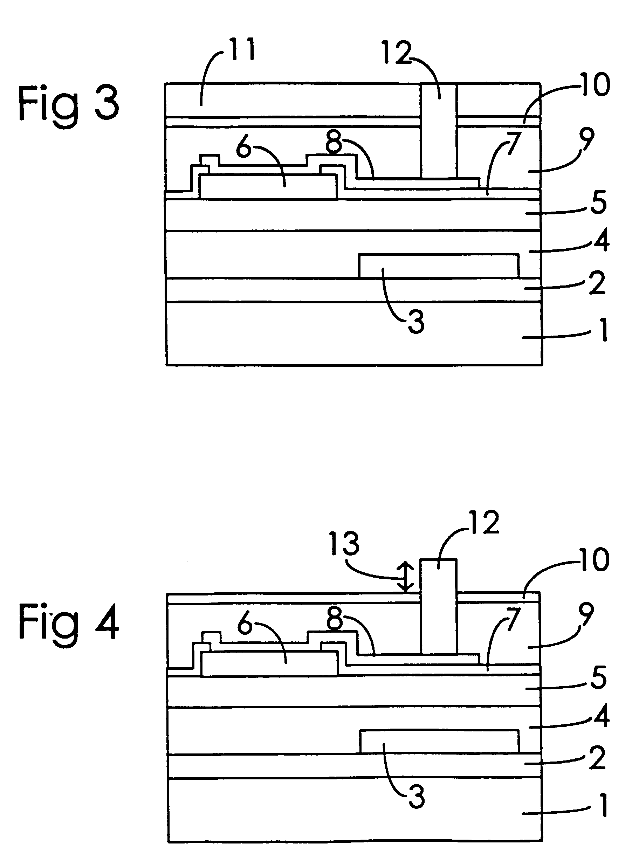

In die obere Dielektrikumschicht 9 wird dann senkrecht ein Loch bis auf die Oberfläche der Anschlußmetallisierung 8 geätzt. Für das weitere Verfahren ist es vorteilhaft, wenn das obere Dielektrikum aus drei Schichtlagen aufgebaut ist, aus einer ersten Dielektrikumschicht 9, einer Ätzstoppschicht 10 und einer darauf aufgebrachten zweiten Dielektrikumschicht 11. Das geätzte Loch wird mit einer weiteren Metallisierung aufgefüllt. Diese weitere Metallisierung kann z. B. Wolfram sein und zunächst so hoch aufgefüllt werden, daß sie die Oberseite der oberen Dielektrikumschicht, hier also der zweiten Dielektrikumschicht 11, bedeckt. Durch ein anschließendes Rückätzen wird erreicht, daß diese Metallisierung als Kontaktstab 12 wie in Fig. 3 gezeigt bis zur Oberseite der obersten Dielektrikumschicht reicht. Als Dielektrikum kommt z. B. SiO₂ in Frage. Bei der gezeigten Struktur ist die Ätzstoppschicht 10 z. B. Si₃N₄.

In einem nachfolgenden Schritt wird das Dielektrikum so weit entfernt, daß der Kontaktstab 12 die Oberseite in einer Höhe 13 wie in Fig. 4 gezeigt überragt. Diese Höhe 13 beträgt z. B. typisch 2 µm. Bei diesem Schritt, der zu der Struktur der Fig. 4 führt, ist die Ätzstoppschicht 10 vorteilhaft. Es kann nämlich die zweite Dielektrikumschicht 11 naßchemisch bis zur Ätzstoppschicht 10 vollständig entfernt werden. Durch die geeignete Wahl der Schichtdicken wird dann erreicht, daß der Kontaktstab 12 die Oberseite der Ätzstoppschicht 10 in der vorgesehenen Höhe 13 überragt. Es können dann, falls erforderlich, Anschlußflächen auf der Oberseite der Metallisierungen oder Leiterbahnen freigeätzt werden.

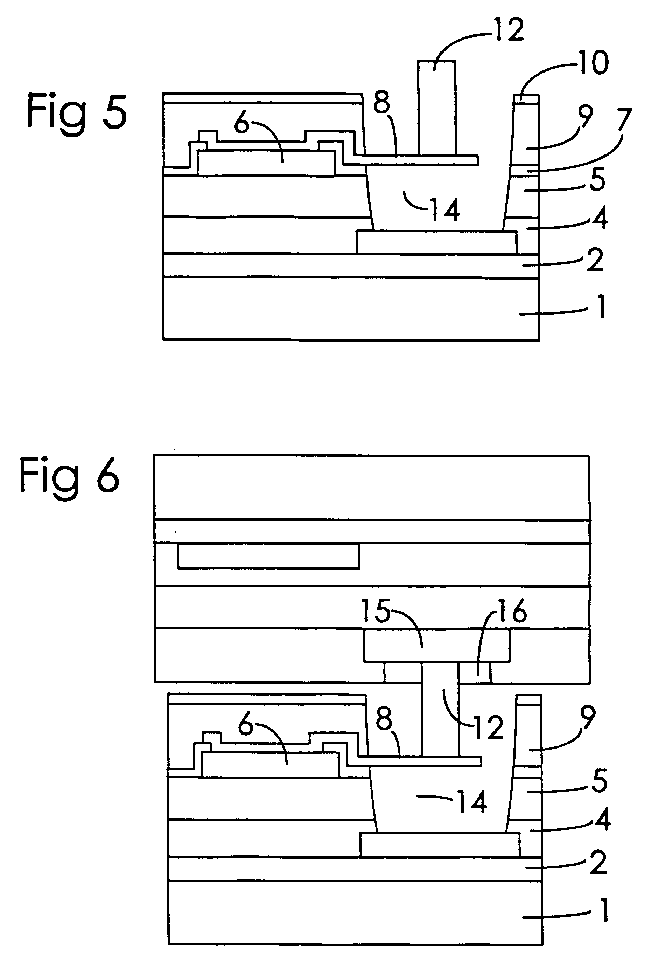

Dann werden der Kontaktstab 12 und der Anteil der Anschlußmetallisierung 8, auf dem dieser Kontaktstab 12 sitzt, ringsum freigeätzt (umgebende Öffnung 14 in Fig. 5), so daß das fertige Bauelement wie in Fig. 5 im Querschnitt gezeigt entsteht. Die Metallisierung 6 ist auf diese Weise über die Anschlußmetallisierung 8 und den Kontaktstab 12 mit einem die Oberseite überragenden, aber bei Andruck federnd nachgebenden Anschlußkontakt versehen.

Bei der in Fig. 6 dargestellen Verbindung dieses Bauelementes mit einem weiteren Bauelement werden die einander zugewandten Oberflächen miteinander in Verbindung gebracht, wobei der Kontaktstab 12 des Bauelementes auf die freie Oberfläche eines Kontaktes 15 in einer Kontaktöffnung 16 des anderen Bauelementes aufgedrückt wird. Da beim Zusammenpressen der Bauelemente der Kontaktstab 12 in die umgebende Öffnung 14 zurückgedrückt wird, können die Oberseiten der Bauelemente in innige Berührung gebracht werden, wobei ein sicherer elektrischer Kontakt auch bei möglichen Unebenheiten der Oberseiten gegeben ist.

Bei der Anordnung der Fig. 6 kann das Bauelement z. B. an einer Halterung angebracht sein, so daß die Kontaktstäbe 12 nach unten gerichtet sind. Das Bauelement kann dann zum Testen des Basis-IC (in Fig. 6 das obere Bauelement) eingesetzt werden. Das Layout der Schaltungen muß dann für diesen Test entsprechend konzipiert sein. Auf diese Weise lassen sich mit dem Bauelement nacheinander die zu testenden IC's reversibel kontaktieren.

Eine weitere Anwendung des Bauelementes ergibt sich bei der vertikalen Integration von Schaltungsebenen. Die verschiedenen Schaltungsebenen werden mit Kontaktstäben versehen. Bei der vertikalen Verbindung erfolgt dann wie beim Testen die elektrische Kontaktierung zunächst reversibel. Wird festgestellt, daß der betreffende Teilstapel seine Funktion nicht erfüllt, kann die zuletzt hinzugefügte Schaltungsebene entfernt werden und durch eine andere ersetzt werden. Wenn ein Test ergibt, daß der Teilstapel seine Funktion erfüllt, kann die zuletzt hinzugefügte Schaltungsebene dauerhaft mit dem restlichen Teilstapel verbunden werden, z. B. indem eine auf der Verbindungsfläche zuvor aufgebrachte Haftschicht z. B. durch Aufheizen aktiviert wird. Diese Haftschicht oder Klebeschicht wird vor dem Zusammenbringen der Schaltungsebene mit dem Teilstapel auf die Oberseite des bereits zusammengefügten Teilstapels aufgebracht. Nach dem Aufbringen dieser Haftschicht werden Öffnungen hergestellt, um die Kontaktflächen für den elektrischen Anschluß mit der nachfolgenden Schaltungsebene freizulegen. Dabei wird in diesen Bereichen die Haftschicht mit entfernt.

Das Bauelement kann im Prinzip beliebig viele federnd gelagerte Kontaktstäbe aufweisen. Zwei miteinander zu verbindende Halbleiterbauelemente können an den miteinander zu verbindenden Oberseiten jeweils sowohl derartige Kontaktstäbe als auch Anschlußflächen aufweisen. Wenn das für die Herstellung verwendete Substrat entfernt wird, kann auch die gegenüberliegende Oberseite des Bauelementes mit rückfedernden Kontaktstäben versehen werden.

## Patentansprüche

1. Verfahren zum Herstellen eines Halbleiterbauelementes,
bei dem in einem ersten Schritt auf ein Substrat (1) eine durch eine vorgesehene Funktionsweise des Halbleiterbauelementes bestimmte Schichtstruktur aufgebracht wird,
bei dem in einem zweiten Schritt eine Isolierungsschicht (7) aufgebracht wird, die einen für elektrischen Anschluß vorgesehenen Bereich frei läßt,
bei dem in einem dritten Schritt eine Anschlußmetallisierung (8) aufgebracht und strukturiert wird,
bei dem in einem vierten Schritt ganzflächig Dielektrikum aufgebracht wird,
bei dem in einem fünften Schritt in diesem Dielektrikum ein Loch hergestellt wird, so daß die Anschlußmetallisierung (8) freigelegt ist,
bei dem in einem sechsten Schritt dieses Loch mit einem Metall zur Bildung eines Kontaktstabes (12) aufgefüllt wird,
bei dem in einem siebten Schritt von dem Dielektrikum so viel entfernt wird, daß der Kontaktstab (12) die Oberseite wie vorgesehen überragt, und
bei dem in einem achten Schritt der Kontaktstab (12) und ein daran angrenzender Anteil der Anschlußmetallisierung (8) durch Ätzen einer umgebenden Öffnung (14) freigelegt werden.

2. Verfahren nach Anspruch 1,
bei dem der vierte Schritt ausgeführt wird, indem ganzflächig eine erste Dielektrikumschicht (9), eine Ätzstoppschicht (10) und eine zweite Dielektrikumschicht (11) aufgebracht werden,
bei dem der fünfte Schritt ausgeführt wird, indem ein Loch in diese Dielektrikumschichten (9, 11) und in diese Ätzstoppschicht (10) geätzt wird, so daß die Anschlußmetallisierung (8) freigelegt ist, und
bei dem der siebte Schritt ausgeführt wird, indem die zweite Dielektrikumschicht (11) bis zur Ätzstoppschicht (10) entfernt wird.

3. Verwendung eines nach einem Verfahren nach einem der Ansprüche 1 oder 2 hergestellten Halbleiterbauelementes zum Testen eines weiteren Halbleiterbauelementes,
bei der die Halbleiterbauelemente mit an diesen Test angepaßten funktionellen Strukturen versehen sind und
bei der die Halbleiterbauelemente so miteinander in Berührung gebracht werden, daß der Kontaktstab (12) des einen Halbleiterbauelementes ausreichend fest für elektrisch leitende Verbindung auf einen Kontakt des anderen Halbleiterbauelementes gedrückt wird.

## Claims

1. Method for the production of a semiconductor component,
in which, in a first step, a layer structure that is determined by the envisaged functioning of the semiconductor component is applied to a substrate (1),
in which, in a second step, an insulating layer (7), which leaves free a region provided for electrical connection, is applied,
in which, in a third step, a connection metallization layer (8) is applied and structured,
in which, in a fourth step, dielectric is applied over the whole area,
in which, in a fifth step, a hole is produced in this dielectric, thereby exposing the connection metallization layer (8),
in which, in a sixth step, this hole is filled with a metal for the purpose of forming a contact bar (12),
in which, in a seventh step, enough of the dielectric is removed for the contact bar (12) to project over the top side in the manner envisaged,
in which, in an eighth step, the contact bar (12) and a portion of the connection metallization layer (8) adjoining the said bar are exposed by etching a surrounding opening (14).

2. Method according to Claim 1,
in which the fourth step is carried out by applying over the whole area a first dielectric layer (9), an etching stop layer (10) and a second dielectric layer (11),
in which the fifth step is carried out by etching a hole into these dielectric layers (9, 11) and into this etching stop layer (10), thereby exposing the connection metallization layer (8), and
in which the seventh step is carried out by removing the second dielectric layer (11) down to the etching stop layer (10).

3. Use of a semiconductor component produced by a method according to either of Claims 1 and 2 for the purpose of testing a further semiconductor component,
in which the semiconductor components are provided with functional structures that are adapted to this test, and
in which the semiconductor components are brought into contact with one another in such a way that the contact bar (12) of one semiconductor component is pressed onto a contact of the other semiconductor component with sufficient strength for electrically conductive connection.

## Revendications

1. Procédé de fabrication d'un composant semi-conducteur, dans lequel, au cours d'une première étape, une structure en couches déterminée par le mode de fonctionnement prévu du composant semi-conducteur est appliquée sur un substrat (1),
dans lequel, au cours d'une deuxième étape, une couche isolante (7) est appliquée, laquelle couche isolante laisse libre une zone prévue pour le raccordement électrique,
dans lequel, au cours d'une troisième étape, une métallisation de raccordement (8) est appliquée et structurée,
dans lequel, au cours d'une quatrième étape, un diélectrique est appliqué sur toute la surface,
dans lequel, au cours d'une cinquième étape, un trou est fabriqué dans ce diélectrique de manière à dégager la métallisation de raccordement (8),
dans lequel, au cours d'une sixième étape, ce trou est rempli d'un métal pour former une barrette de contact (12),
dans lequel, au cours d'une septième étape, on élimine le diélectrique dans une mesure telle que la barrette de contact (12) dépasse la face supérieure de la manière prévue, et
dans lequel, au cours d'une huitième étape, la barrette de contact (12) et une partie de la métallisation de raccordement (8) contiguë à celle-ci sont dégagées par la formation par attaque chimique d'une ouverture périphérique (14).

2. Procédé selon la revendication 1,
dans lequel, pour exécuter la quatrième étape, une première couche de diélectrique (9), une couche stoppant la gravure (10) et une seconde couche de diélectrique (11) sont appliquées sur toute la surface,
dans lequel, pour exécuter la cinquième étape, un trou est formé par attaque chimique dans ces couches de diélectrique (9, 11) et dans cette couche stoppant la gravure (10), de manière à ce que la métallisation de raccordement (8) soit dégagée, et
dans lequel, pour exécuter la septième étape, la seconde couche de diélectrique (11) est éliminée jusqu'à la couche stoppant la gravure (10).

3. Utilisation d'un composant semi-conducteur fabriqué selon un procédé selon l'une des revendications 1 ou 2 pour tester un autre composant semi-conducteur,
dans laquelle les composants semi-conducteurs sont pourvus de structures fonctionnelles adaptées à ce test et
dans laquelle les composants semi-conducteurs sont mis en contact l'un avec l'autre de manière à ce que la barrette de contact (12) de l'un des composants semi-conducteurs soit pressée de manière suffisamment forte sur un contact de l'autre composant semi-conducteur pour une liaison électroconductrice.
